## Europäisches Patentamt
## European Patent Office
## Office européen des brevets

(19)

(11) Veröffentlichungsnummer : **0 218 105**
**B1**

(12) # EUROPÄISCHE PATENTSCHRIFT

(45) Veröffentlichungstag der Patentschrift :
09.08.89

(21) Anmeldenummer : 86112349.5

(22) Anmeldetag : 06.09.86

(51) Int. Cl.⁴ : **H 01 J   1/18, H 01 J 37/06**

(54) Einspannvorrichtung für spiralförmige Drahtkatoden.

(30) Priorität : 30.09.85 DE 3534793

(43) Veröffentlichungstag der Anmeldung :
15.04.87 Patentblatt 87/16

(45) Bekanntmachung des Hinweises auf die Patenterteilung : 09.08.89 Patentblatt 89/32

(84) Benannte Vertragsstaaten :
BE CH DE FR GB LI

(56) Entgegenhaltungen :
DE–A– 2 723 891
THE REVIEW OF SCIENTIFIC INSTRUMENTS, Band 42, Nr. 6, Juni 1971, Seiten 822,823; S.R. QUIGLEY: "An electron bombardment substrate heater for use with very thin, high resistivity substrates"

(73) Patentinhaber : **LEYBOLD AKTIENGESELLSCHAFT**
**Wilhelm-Rohn-Strasse 25**
**D-6450 Hanau am Main (DE)**

(72) Erfinder : **Kraft, Reinhard**
**Mittelstrasse 53**
**D-6472 Altenstadt-Höchst (DE)**
Erfinder : **Ranke, Horst, Dr.**
**Brentanostrasse 34**
**D-8755 Alzenau (DE)**

(74) Vertreter : **Zapfe, Hans, Dipl.-Ing.**
**Am Eichwald 7**
**D-6056 Heusenstamm 2 Rembrücken (DE)**

EP 0 218 105 B1

**Beschreibung**

Die Erfindung betrifft eine Einspannvorrichtung für aus Draht in einer Ebene spiralförmig gebogene, durch Stromdurchgang beheizbare Katoden in Elektronenstrahlerzeugern mit zwei über einen Isolierkörper miteinander verbundenen Tragstützen.

Derartige Elektronenstrahlerzeuger werden als Quelle von Elektronenstrahlen hoher Leistung verwendet, wie sie für das Schmelzen und/oder Verdampfen von Werkstoffen im Vakuum benötigt werden. Dabei wird die im wesentlichen aus einer massiven Kreisscheibe bestehende Blockkatode im allgemeinen durch eine aus Draht bestehende, wendelförmig gebogene direkt beheizte Katode durch Elektronenbeschuß aufgeheizt und sendet nun ihrerseits aufgrund einer im System vorhandenen Beschleunigungsspannung einen gebündelten Elektronenstrahl aus.

Bei einer bekannten Einspannvorrichtung der eingangs beschriebenen Gattung sind die beiden Enden der Drahtkatode parallel zur Achse des gesamten Strahlerzeugersystems ausgerichtet und in aus Tantal bestehenden Zylinderstücken gelagert, die zum Zwecke der notwendigen Justierung der Katode exzentrische Bohrungen für die Katodenenden aufweisen. Die Zylinderstücke werden ihrerseits wiederum durch aus Graphit bestehende Oberwurfmuttern gegen hohle metallische Anschlußbolzen verspannt, die ihrerseits mit einem gemeinsamen Isolierkörper verbunden sind. Jede der aus den Zylinderstücken, der Oberwurfmutter und dem hohlen Anschlußbolzen bestehende Baugruppe stellt eine sogenannte Tragstütze dar.

Bei der bekannten Lösung wird es als nachteilig empfunden, daß die Exzenterverstellung der Anschlußenden der Drahtkatode keine definierte Einbaulage ermöglicht, und zwar weder hinsichtlich der Höheneinstellung, noch hinsichtlich der Zentrizität. Der Einbau ist umständlich, wobei auch noch Kontaktprobleme auftreten, die zu einem häufigen Austausch der Katoden wegen einer Oxidation im Bereich der Tragstützen, insbesondere der Graphitüberwurfmuttern, führen. Hinzukommt, daß durch die große Länge der Anschlußenden der Katode ein thermischer Verzug der Katode unvermeidlich ist, der eine erst mühsam erreichte Justierung nachträglich wieder zunichte macht. Nach erstmaligem Aufheizen der Drahtkatode ist jedoch ein Richten durch Biegen nicht mehr möglich, da das spröde Katodenmaterial (Wolfram) kein nachträgliches Biegen mehr zuläßt.

Aus der DE-A-2 723 891 ist ein Elektronenstrahlerzeuger mit einer aus Draht in Form einer Flachspirale gebogenen Katode bekannt. Als Stromanschlüsse und zur zentrischen Halterung der Flachspirale dienen ein rechtwinklig in Richtung der Spiralenachse abgebogenes Ende des Katodendrahtes einerseits und der äußere Umfang der äußersten Spiralenwindung andererseits. Diese äußerste Spiralenwindung ist ihrerseits in einer ringförmigen Aussparung einer rohrförmigen Stromzuführung gehalten. Zum Zwecke eines Auswechselns der Spiralkatode bzw. deren Reste, ist die Verwendung eines scharfen Werkzeuges erforderlich, wobei auch beim Einsetzen einer neuen Katode eine erhebliche elastische Verformung der aus sprödem Material bestehenden Katodenwindungen unvermeidbar ist. Etwaige Reste des zentrischen Anschlußendes müssen dabei in die hohle Stromzuführung durchgestoßen werden, sodaß nach einiger Betriebsdauer die gesamte Anordnung zerlegt werden muß, um die angehäuften Drahtreste zu entfernen. Unterschiedliche thermische Ausdehnungen einzelner Bauelemente eines solchen Systems führen zu einer Verformung der Spiralenebene in Richtung auf eine Kegelfläche mit großem Öffnungswinkel. Weiterhin herrscht in der bekannten Spiralkatode aufgrund unvermeidbarer Fertigungstoleranzen eine erhebliche Vorspannung, da es im allgemeinen unmöglich ist, die äußere Windung einer Spirale in einer Ringnut zu halten und hierbei gleichzeitig den Mittelpunkt der Spirale in die Achse des Systems zu bringen.

Der Erfindung liegt die Aufgabe zugrunde, eine Einspannvorrichtung für Drahtkatoden dahingehend zu verbessern, daß der spiralförmig gebogene Teil dieser Katoden eine noch exaktere Lage zu den darumherum angeordneten strahlformenden Teilen erhält und zwar sowohl hinsichtlich der Einbauhöhe als auch hinsichtlich der Zentrizität. Zusätzlich soll auch eine einwandfreie langlebige Übertragung des verhältnismäßig hohen Heizstromes möglich sein (geringerer Übergangswiderstand).

Die Lösung der gestellten Aufgabe erfolgt bei der eingangs beschriebenen Einspannvorrichtung erfindungsgemäß dadurch, daß die Tragstützen sektorförmige Ausschnitte aus einem metallischen Hohlzylinder darstellen und an ihren dem Isolierkörper abgekehrten Enden an den einander gegenüberliegenden Seiten je eine Umfangsnut aufweisen, wobei die die Nuten begrenzenden Flächen Teile gemeinsamer Kreis- bzw. Zylinderflächen sind, sowie dadurch, daß die Enden der Katode in etwa auf einem Kreis liegen, dessen Ebene zur Ebene der Spirale parallel verläuft und komplementär zu den Nuten in den Tragstützen ausgebildet sind, derart, daß diese Enden federelastisch und formschlüssig in den Umfangsnuten liegen.

Die Form der Katode läßt sich auch dadurch ausdrücken, daß ihre Anschlußenden in eine zur Katodenachse radiale Ebene abgewinkelt und in dieser Ebene etwa kreisförmig gebogen sind, wobei der Krümmungsradius in Richtung auf die Enden zunimmt.

Auf die angegebene Weise werden zwei zueinander parallel verlaufende Ebenen definiert, nämlich eine erste Ebene, in der der spiralförmig gewendelte Teil der Katode liegt, und eine zweite Ebene, in der die kreisförmig gebogenen Anschlu-

ßenden der Katode liegen. Beide Ebenen haben einen exakt definierten Abstand voneinander und verlaufen auch genau senkrecht zur Systemachse des Strahlerzeugers. Die Verbindung zwischen diesen beiden Enden erfolgt dann nur durch schräg verlaufende Verbindungsstücke, die unmittelbar in den spiralförmig gewendelten Teil übergehen. Durch diese Maßnahme läßt sich nicht nur eine exakte Einbauhöhe, sondern auch noch eine absolut genaue Zentrizität des Mittelpunktes des spiralförmigen Teils erzielen. Die Länge der Anschlußenden ist auf ein Minimum reduziert, und durch die gute Kontaktgabe in den Umfangsnuten unter Vorspannung gibt es auch nur verhältnismäßig geringe Übergangswiderstände, die eine lange Standzeit der Drahtkatode ermöglichen. Die teuren aus Tantal bestehenden Zylinderstücke sowie die gleichfalls teuren Graphit-Oberwurfmuttern werden vermieden. Dadurch unterbleibt auch außerordentlich weitgehend ein nachträglicher thermischer Verzug der gesamten Katode. Außerdem wird ein schneller Katodenwechsel ermöglicht.

Ein Ausführungsbeispiel des Erfindungsgegenstandes wird nachfolgend anhand der Figuren 1 bis 6 näher erläutert.

Es zeigen :

Figur 1 einen Axialschnitt durch einen vollständigen Elektronenstrahlerzeuger.

Figur 2 den Gegenstand nach Figur 1 in der Draufsicht und nach oben geöffnet, so daß die Einspannvorrichtung sichtbar ist,

Figur 3 eine perspektivische Unteransicht der wesentlichen Teile der Einspannvorrichtung,

Figur 4 eine perspektivische Oberansicht des Gegenstandes nach Figur 3,

Figur 5 einen Axialschnitt durch die Katode und die oberen Enden der Tragstützen und

Figur 6 eine Draufsicht auf den Gegenstand von Figur 5 unter Weglassung der Tragstützen.

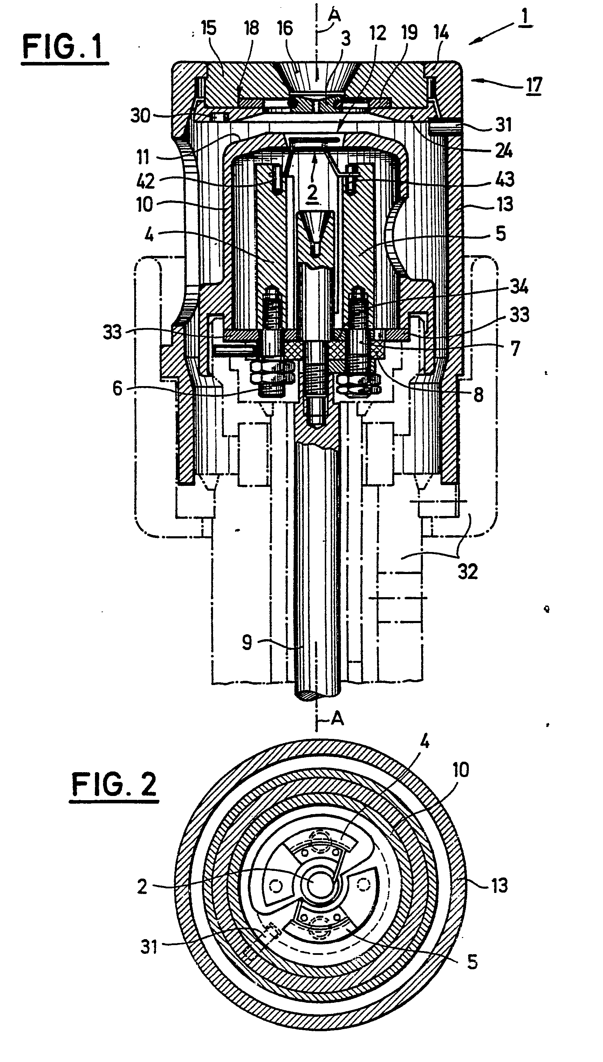

In Figur 1 ist ein Elektronenstrahlerzeuger 1 gezeigt, der eine direkt beheizbare erste Katode 2 und eine durch die erste Katode indirekt beheizbare zweite Katode 3, die sogenannte Blockkatode aufweist. Die erste Katode 2 besteht in ihrem zentralen Teil aus einem spiralförmig gebogenen Teil, der über zwei nach hinten und außen führende Anschlußenden mit metallischen Tragstützen 4 und 5 verbunden sind, über die gleichzeitig die Stromzufuhr bewirkt wird. Die Tragstützen 4 und 5 sind mittels zweier Anschlußbolzen 6 und 7 an einem Isolierkörper 8 gehalten, der seinerseits wieder an einer Tragstange 9 befestigt ist, die gleichzeitig zur Stromzuführung zum rechten Anschlußbolzen 7 führt. Die Stromzuführung zum Anschlußbolzen 6 ist nicht näher gezeigt. Die vorstehend beschriebene Anordnung ist in einer inneren Fokussierungselektrode 10 untergebracht, die in ihrer Stirnseite 11 eine koaxiale Bohrung 12 aufweist, in der die erste Katode 2 angeordnet ist. Dadurch wird ein in Betrieb nach oben (bezogen auf Figur 1) gerichtetes Strahlenbündel erzeugt, das auf die Blockkatode 3 auftrifft und in Abhängigkeit von der Steuerung der Potentialdifferenz eine mehr oder weniger starke Aufheizung der Blockkatode 3 bewirkt, so daß diese nun ihrerseits eine wiederum nach oben gerichtetes Strahlenbündel aussendet.

Die innere Fokussierungselektrode 10 ist konzentrisch von einem Hohlzylinder 13 umgeben, der einen Stirnflansch 14 aufweist. In die dadurch gebildete kreisförmige Öffnung ist ein scheibenförmiger Teil 15 so eingesetzt, daß seine zentrische Bohrung 16 konzentrisch zur gemeinsamen Achse A-A des gesamten Systems verläuft. Der scheibenförmige Teil 15 stützt sich über eine nicht näher bezeichnete Schulterfläche am Stirnflansch 14 ab. Der Hohlzylinder 13 und der scheibenförmige Teil 15 bilden zusammen eine äußere Fokussierungselektrode 17.

Im scheibenförmigen Teil 15 befindet sich eine zur Bohrung 16 konzentrische erste Zentrierfläche 18, die als schmale Zylinderfläche ausgebildet ist. Die von der Zentrierfläche 18 begrenzte zylindrische Ausnehmung dient zur Aufnahme einer Baugruppe mit der Blockkatode 3 und einen Tragring 19 für die Blockkatode. Dieser Tragring besitzt eine zur ersten Zentrierfläche 18 komplementäre nicht näher bezeichnete zweite Zentrierfläche. Es versteht sich, daß zwischen der Blockkatode 3 und dem Innendurchmesser des Tragrings 19 ein ausreichend großer Abstand vorhanden ist.

Der Tragring 19 ist im scheibenförmigen Teil 15 durch einen Verriegelungsring 24 gehalten, dessen Innendurchmesser dabei im wesentlichen dem Innendurchmesser des Tragrings 19 entspricht. Auf seinem äußeren Umfang besitzt der Verriegelungsring 24 zwei radiale Nuten, die sich über die gesamte Dicke des Verriegelungsrings erstrecken. Von diesen Nuten gehen zwei in Umfangsrichtung verlaufende schiefe Ebenen aus, deren Endkanten in der unteren Begrenzungsfläche des Verriegelungsrings 24 liegen. Weiterhin sind zwei Bohrungen 30 vorhanden, die zum Ansetzen eines Werkzeugs zum Zwecke des Verdrehens des Verriegelungsringes 24 dienen.

Zum Festlegen des Verriegelungsringes, dessen Außendurchmesser etwa dem Innendurchmesser des Hohlzylinders 13 entspricht, sind in diesem Hohlzylinder an diametral gegenüberliegenden Stellen zwei Zylinderzapfen 31 angeordnet, von denen nur einer gezeigt ist. Aufgrund der in ihm vorhandenen Nuten läßt sich der Verriegelungsring 24 zwischen die Zylinderzapfen 31 und den scheibenförmigen Teil 15 bringen. Durch Verdrehen des Verriegelungsringes 24 gleiten die oben genannten schiefen Ebenen über die Zylinderzapfen 31, so daß der Verriegelungsring 24 gegen die Zylinderzapfen 31 einerseits und gegen den scheibenförmigen Teil 15 andererseits verspannt wird. Dabei wird der Teil 15 seinerseits gegen den Stirnflansch 14 gepreßt. Die den Strahlerzeuger bildenden Teile sind in einer Halterung 32 befestigt, die jedoch nur strichpunktiert angedeutet ist, weil sie nicht mehr Teil der Erfindung ist.

Bei der Schnittdarstellung in Figur 2 sind die oberhalb der oberen Stirnseiten der Tragstützen 4 und 5 liegenden Teile der inneren Fokussierungselektrode 10 und der äußeren Fokussierungselektrode 17 entfernt, so daß eine Draufsicht auf die Einspannvorrichtung mit den Tragstützen 4 und 5 möglich ist.

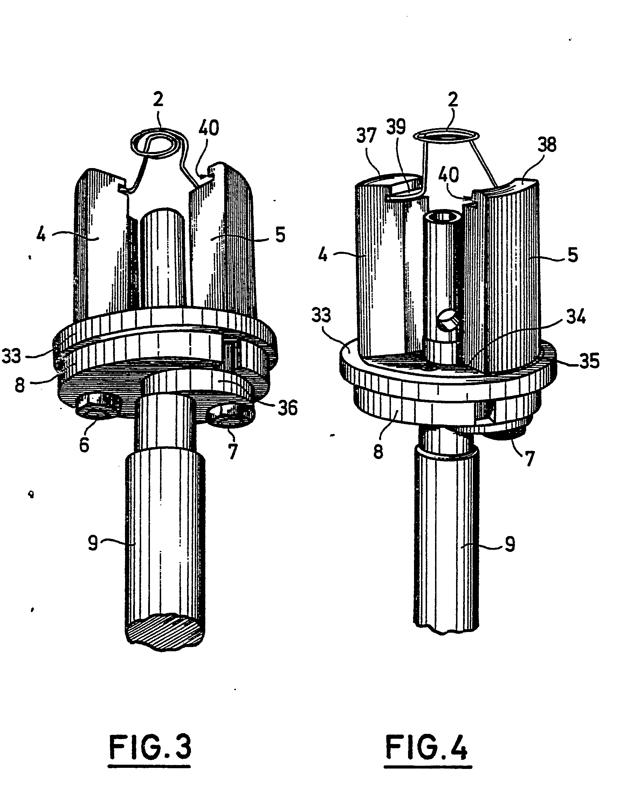

Aus den Figuren 3 und 4 ist ersichtlich, daß die beiden Tragstützen sektorförmige Ausschnitte aus einem metallischen Hohlzylinder sind. Die Sektoren sind dabei so mit dem Isolierkörper 8 verbunden, daß ihre inneren und äußeren Zylinderflächen in den ursprünglichen Zylinderflächen liegen. Es ist dabei nicht erforderlich, daß die Seitenflächen der Sektoren in genau radialer Richtung verlaufen.

Die Tragstützen besitzen an ihren unteren Enden Grundplatten 33 und 34, deren obere und untere Begrenzungsflächen in koplanaren Ebenen liegen. Die Grundplatten ergänzen sich unter Belassung von Isolierabständen im wesentlichen zu einer Kreisscheibe, deren Achse mit der Achse A-A zusammenfällt. Die mit der Tragstütze 4 verbundene Grundplatte 33 ist dabei auch in Form eines Kreisrings unter Zwischenschaltung eines Isolierabstandes 35 um die gegenüberliegende Tragstütze 5 herumgeführt, wie dies insbesondere in den Figuren 1 und 4 erkennbar ist. Die Festlegung der beiden Grundplatten zusammen mit den Tragstützen erfolgt dabei durch die bereits beschriebenen Anschlußbolzen 6 und 7, die zu diesem Zweck durch den Isolierkörper 8 hindurchgeführt und an ihren unteren Enden mit Muttern versehen sind. Es ist insbesondere Figur 3 auch zu entnehmen, daß die Tragstange 9 über eine radiale Lasche 36 elektrisch leitend mit dem Anschlußbolzen 7 verbunden ist. Die Anschlußbolzen 6 und 7 sind, wie in Fig. 1 gezeigt, in die Tragstützen 4 und 5 eingeschraubt.

Die Tragstützen 4 und 5 besitzen Stirnseiten 37 und 38, die in einer gemeinsamen Ebene liegen. Knapp unterhalb dieser Ebene ist je eine Umfangsnut 39 bzw. 40 angeordnet, deren Nutengrund 41 konzentrisch zur Achse A-A verläuft. Die die Nuten begrenzenden Flächen sind (einschließlich des Nutengrundes 41) Teile gemeinsamer Kreis- bzw. Zylinderflächen. Die jeweils unteren Begrenzungsflächen der Nuten sind größer bzw. ragen radial weiter einwärts als die oberen Begrenzungsflächen, wodurch an den Innenkanten der Tragstützen 4 und 5 stufenförmige Absätze gebildet werden.

In den unteren Begrenzungsflächen der Nuten 39 und 40 sind an diametral gegenüberliegenden Stellen und an den Enden der Nuten zur Achse A-A parallele Zylinderstifte 42 und 43 angeordnet, die den Nuten radial einwärts vorgelagert sind, aber zwischen sich und dem Nutengrund 41 Abstände von solcher Größe freilassen, daß die Einspannenden 44 und 45 der Katode durch eine Drehbewegung derselben hinter die Zylinderstifte 42 und 43 einführbar sind (Fig. 1, 5 und 6), bis die in einer diametralen Ebene liegenden Verbindungsstücke 46 und 47 an die Zylinderstifte 42 und 43 anstoßen.

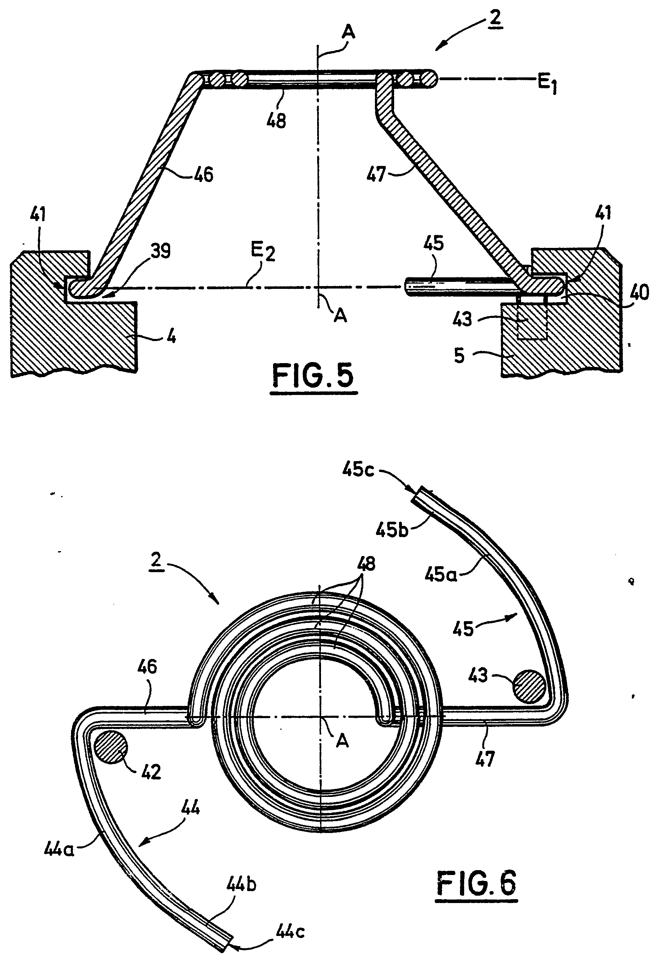

Die Raumform der Katode 2 ist in den Fig. 5 und 5 besonders deutlich dargestellt: die Katode 2 besitzt einen spiralförmig gebogenen Teil 48 mit dem Mittelpunkt in der Achse A-A. Der Teil 48 ist der Elektronen emittierende Teil, der in einer ersten radialen Ebene $E_1$ liegt. Vom Teil 48 führen die Verbindungsstücke 46 und 47 zu den Einspannenden 44 und 45. Diese weisen wiederum Teilabschnitte 44a und 45a bzw. 44b und 45b mit unterschiedlichen Krümmungsradien auf, und zwar entspricht der Krümmungsradius der Teilabschnitte 44a und 45a dem mittleren Krümmungsradius des Nutengrundes 41, während der Krümmungsradius der sich anschließenden Teilabschnitte 44b und 45b deutlich größer und vorzugsweise unendlich ist, d. h. bis zu den Stirnflächen 44c und 45c verlaufen die Einspannenden 44 und 45 über die Teilabschnitte 44b und 45b geradlinig. Dadurch wird eine verbesserte Kontaktgabe erreicht. Die Einspannenden 44 und 45 verlaufen mit ihren Mittenachsen in einer zweiten, zur Achse A-A radialen Ebene $E_2$. Die Einspannenden liegen aufgrund ihrer Form und Vorspannung federelastischen und formschlüssig in den Umfangsnuten 39 und 40.

Durch eine Drehung im Uhrzeigersinne aus der Position gem. Fig. 6 läßt sich die Katode 2 leicht aus den Umfangsnuten 39 und 40 herausdrehen, und eine neue Katode läßt sich durch entgegengesetzte Drehung leicht wieder einsetzten, bis die Verbindungsstücke 46 und 47 an den Zylinderstiften 42 und 43 zur Anlage kommen. Die Katode ist jetzt unter guter Kontaktgabe einwandfrei in der Bohrung 12 nach Achslage (Höhe) und in radialer Richtung zentriert.

## Patentansprüche

1. Einspannvorrichtung für aus Draht in einer Ebene spiralförmig gebogene, durch Stromdurchgang beheizbare Katoden in Elektronenstrahlerzeugern, mit zwei über einen Isolierkörper miteinander verbundenen Tragstützen, dadurch gekennzeichnet, daß die Tragstützen (4, 5) sektorförmige Ausschnitte aus einem Hohlzylinder darstellen und an ihren dem Isolierkörper (8) abgekehrten Enden an den einander gegenüberliegenden Seiten je eine Umfangsnut (39, 40) aufweisen, wobei die die Nuten begrenzenden Flächen Teile gemeinsamer Kreis- bzw. Zylinderflächen sind, sowie dadurch, daß die Einspannenden (44, 45) der Katode (2) in etwa auf einem Kreis liegen, dessen Ebene zur Ebene der Spirale parallel verläuft, und komplementär zu den Nuten (39, 40) in den Tragstützen (4, 5) ausgebildet sind, derart, daß diese Einspannenden (44, 45) federelastisch und formschlüssig in den Umfangsnuten (39, 40) liegen.

2. Einspannvorrichtung nach Anspruch 1, dadurch gekennzeichnet, daß die Einspannenden (44, 45) der Katode (2) von innen nach außen, zunächst einen mittleren Krümmungsradius aufweisen, der dem mittleren Krümmungsradius der Umfangsnuten (39, 40) entspricht, und daß der Krümmungsradius der Einspannenden (44, 45) in Richtung auf die Stirnflächen (44c, 45c) vergrößert ist.

3. Einspannvorrichtung nach Anspruch 1, dadurch gekennzeichnet, daß die Umfangsnuten (39, 40) im Bereich der Innenkanten von stufenförmigen Absätzen an den Enden der Stützkörper (4, 5) angeordnet sind.

4. Einspannvorrichtung nach Anspruch 3, dadurch gekennzeichnet, daß die Umfangsnuten (39, 40) je einen Nutengrund (41) aufweisen, vor dem radial die einwärts am Ende einer jeden Umfangsnut (39, 40) diametral gegenüberliegend je ein Zylinderstift (42, 43) angeordnet ist, hinter den jeweils ein Einspannende (44, 45) der Katode (2) in die zugehörige Umfangsnut einschiebbar ist.

5. Einspannvorrichtung nach Anspruch 1, dadurch gekennzeichnet, daß die Tragstützen (4, 5) auf mit dem Isolierkörper verbundenen Grundplatten (33, 34) angeordnet sind, die sich unter Belassung von Isolierabständen (35) im wesentlichen zu einer Kreisscheibe ergänzen, deren Achse mit der Achse A-A zusammenfällt.

## Claims

1. A mounting arrangement for cathodes in electron guns, which cathodes are bent spirally from wire in one plane and are heatable by a flow of current, said mounting arrangement having two support members which are interconnected by way of an insulating member, characterised in that the support members (4, 5) constitute sector-shaped sections of a hollow cylinder and have a respective circumferential groove (39, 40) on each mutually opposite side at their ends remote from the insulating member (8), the surfaces defining the grooves being parts of common circular or cylindrical surfaces, and in that the mounting ends (44, 45) of the cathode (2) lie approximately on a circle whose plane extends parallel to the plane of the spiral, and are constructed complementarily to the grooves (39, 40) in the support members (4, 5) in such a way that the said mounting ends (44, 45) are located resiliently and frictionally in the circumferential grooves (39, 40).

2. A mounting arrangement as claimed in claim 1, characterised in that the mounting ends (44, 45) of the cathode (2) have, from the inside to the outside, first an average radius of curvature which corresponds to the average radius of curvature of the circumferential grooves (39, 40), and that the radius of curvature of the mounting ends (44, 45) is increased towards the end faces (44c, 45c).

3. A mounting arrangement as claimed in claim 1, characterised in that the circumferential grooves (39, 40) are disposed in the region of the inner edges of stepshaped shoulders at the ends of the support members (4, 5).

4. A mounting arrangement as claimed in claim 3, characterised in that each circumferential groove (39, 40) has a bottom (41) in front of which a respective one of cylindrical pins (42, 43), located diametrically opposite one another, is disposed radially inwards at the end of each circumferential groove (39, 40), a respective mounting end (44, 45) of the cathode (2) being insertable behind each said cylindrical pin into the associated circumferential groove.

5. A mounting arrangement as claimed in claim 1, characterised in that the support members (4, 5) are disposed on base plates (33, 34) which are connected to the insulating member and which, leaving insulating spaces (35), complement one another substantially to form a circular disc whose axis coincides with the axis A-A.

## Revendications

1. Dispositif de fixation pour cathodes chauffées par passage de courant, faites en fil courbé en spirale dans un plan, dans des générateurs de faisceau électronique, comprenant deux supports assemblés l'un à l'autre par un corps isolant, caractérisé par le fait que les supports (4, 5) sont constitués par des portions en forme de secteur d'un cylindre creux et présentent chacun en son extrémité non tournée vers le corps isolant (8), dans son côté en regard de l'autre, une rainure périmétrique (39, 40), les surfaces délimitant les rainures étant des parties de surfaces circulaires ou cylindriques communes, et par le fait que les extrémités de fixation (44, 45) de la cathode (2) se trouvent sensiblement sur un cercle dont le plan est parallèle au plan de la spirale et ont une configuration telle qu'elles sont complémentaires par rapport aux rainures (39, 40) dans les supports (4, 5), de manière que ces extrémités de fixation (44, 45) se placent avec une élasticité de ressort, en établissant une liaison mécanique positive, dans les rainures périmétriques (39, 40).

2. Dispositif de fixation selon revendication 1, caractérisé par le fait que les extrémités de fixation (44, 45) de la cathode (2) présentent, de l'intérieur vers l'extérieur, d'abord un rayon de courbure moyen qui correspond au rayon de courbure moyen des rainures périmétriques (39, 49), et par le fait que le rayon de courbure des extrémités de fixation (44, 45) augmente en direction des surfaces frontales extrêmes (44c, 45c).

3. Dispositif de fixation selon revendication 1, caractérisé par le fait que les rainures périmétriques (39, 40) sont aménagées dans la région des bords intérieurs de parties étagées en forme de gradin aux extrémités des supports (4, 5).

4. Dispositif de fixation selon revendication 3, caractérisé par le fait que chacune des rainures périmétriques (39, 40) présente un fond (41) devant lequel est située, radialement vers l'intérieur, à chaque fois à l'extrémité de la rainure périmétrique (39, 40), une broche cylindrique (42, 43) diamétralement opposée à l'autre broche cylindrique, une extrémité de fixation (44, 45) de la cathode (2) pouvant être introduite derrière chaque broche, dans la rainure périmétrique correspondante.

5. Dispositif de fixation selon revendication 1, caractérisé par le fait que les supports (4, 5) sont agencés sur des plaques de base (33, 34) assemblées par le corps isolant, lesquelles, tout en laissant subsister des intervalles d'isolement (35), se complètent sensiblement en formant un disque dont l'axe coïncide avec l'axe A-A.

FIG.1

FIG. 2

FIG.3

FIG.4

FIG.5

FIG.6